(19) Europäisches Patentamt
European Patent Office
Office européen des brevets

(11) Publication number: 0 391 279 A2

(12) **EUROPEAN PATENT APPLICATION**

(21) Application number: 90106176.2

(51) Int. Cl.5: G01R 33/46

(22) Date of filing: 30.03.90

(30) Priority: 04.04.89 JP 85385/89

(43) Date of publication of application: 10.10.90 Bulletin 90/41

(84) Designated Contracting States: DE NL

(71) Applicant: KABUSHIKI KAISHA TOSHIBA
72, Horikawa-cho Saiwai-ku
Kawasaki-shi Kanagawa-ken 210(JP)

(72) Inventor: Sugiura, Satoshi
1961-10 Usuba
Ootawara-shi, Tochigi-ken(JP)

(74) Representative: Blumbach Weser Bergen
Kramer Zwirner Hoffmann Patentanwälte
Radeckestrasse 43
D-8000 München 60(DE)

(54) **Method and apparatus for nuclear magnetic resonance spectroscopy with optimal RF power setting.**

(57) A method and an apparatus for nuclear magnetic resonance spectroscopy capable of obtaining the optimal setting of the RF power for each chemical component of interest, such that the nuclear magnetic resonance spectroscopic images or the localized spectrum with improved signal/noise ratio become obtainable. In the apparatus, the optimal RF power setting is obtained by changing the setting of the RF power sequentially to a plurality of different levels; then for each setting of the RF power, a signal strength of the nuclear magnetic resonance signals for the target chemical component is determined from the spectral data derived from the nuclear magnetic resonance signals, and the optimal RF power setting for which the signal strength of the nuclear magnetic resonance signals for the target chemical component is maximum is determined in accordance with the signal strength determined for each setting of the RF power.

EP 0 391 279 A2

# METHOD AND APPARATUS FOR NUCLEAR MAGNETIC RESONANCE SPECTROSCOPY WITH OPTIMAL RF POWER SETTING

## BACKGROUND OF THE INVENTION

### Field of the Invention

The present invention relates to a method and an apparatus for nuclear magnetic resonance spectroscopy in which spectral data for a plurality of chemical components in a body to be examined are obtained by utilizing the principle of nuclear magnetic resonance.

### Description of the Background Art

In a conventional nuclear magnetic resonance spectroscopy, spectral data for a plurality of chemical components in a body to be examined, such as $^{1}H$, $^{31}P$, $^{19}F$, $^{23}Na$, and $^{13}C$, or nuclear magnetic resonance spectroscopic images with a particular chemical component emphasized are obtained by placing the body to be examined in a static and homogeneous magnetic field, applying constant or pulsed gradient magnetic fields in order to specify a region to be examined, irradiating with a high frequency pulsed magnetic field in a direction perpendicular to the static magnetic field, which is commonly referred to as RF (radio frequency) pulse, in order to cause nuclear magnetic resonance phenomena for the nuclei in the region to be examined, and collecting nuclear magnetic resonance signals resulting from the irradiation of the RF pulse.

Here, the RF pulse actually functions to tilt magnetic moments of spin systems for a prescribed angle called a flip angle with respect to a direction of the static magnetic field.

Now, in order to obtain the nuclear magnetic resonance spectroscopic images at high signal/noise ratio, it is necessary to obtain strong nuclear magnetic resonance signals.

The signal strength S for the nuclear magnetic resonance signals is known to be given by the formula:

$$S = \frac{k \cdot (1 - e^{(-TR/T1)}) \cdot \sin\theta}{1 - e^{(-TR/T1)} \cdot \cos\theta}$$

where k is a constant, $\theta$ is the flip angle, TR is a pulse interval (repeat time), and T1 is a time constant for a relaxation time of a spin.

The relationship between the signal strength and the ratio TR/T1 appearing in the above formula is plotted in Fig. 1 for various flip angles, which shows that for each value of the flip angle, there exists a particular value for the ratio TR/T1 for which the signal strength becomes maximum.

The collection of the nuclear magnetic resonance signals is carried out as follows. First, T1 is uniquely determined when a target chemical component is specified, while TR is determined from imaging conditions such as those related to a type of pulse sequence. Thus, the ratio TR/T1 can be determined unambiguously. On the other hand, the flip angle $\theta$ is determined from RF power, but the RF power depends on a local magnetic field strength around the spin due to influences from characteristics of the body to be examined such as a shape and a size, as well as characteristics of the apparatus, so that an accurate setting of the flip angle $\theta$ is very difficult.

For this reason, the setting of the RF power in a conventional nuclear magnetic resonance spectroscopy has been relying on a discretion of an operator, and it has been difficult to set the RF power accurately to that for which the signal strength becomes maximum. Consequently, the signal/noise ratio for the nuclear magnetic resonance spectroscopic images have been low in a conventional nuclear magnetic resonance spectroscopy, as the optimal setting of the RF power for each chemical component of interest has not been achieved.

## SUMMARY OF THE INVENTION

It is therefore an object of the present invention to provide a method and an apparatus for nuclear magnetic resonance spectroscopy capable of obtaining the optimal setting of the RF power for each chemical component of interest, such that the nuclear magnetic resonance spectroscopic images with improved signal/noise ratio become obtainable.

According to one aspect of the present invention there is provided a method of nuclear magnetic resonance spectroscopy, comprising the steps of: (a) selecting a target chemical component; (b) setting an RF power to be supplied to an RF pulse applying means to a level for which a signal strength of nuclear magnetic resonance signals for the target chemical component selected at the step (a) is maximum, by: (1) changing the setting of the RF power sequentially to a plurality of different levels; (2) for each setting of the RF power, (2a) applying RF pulses to an object to be examined placed under a static magnetic field and gradient magnetic fields; (2b) collecting the nuclear magnetic resonance signals from the object to be examined due to the RF pulses applied at the step (2a); (2c) deriving spectral data from the nuclear magnetic resonance signals collected at the step (2b); and (2d) determining a signal strength of the nuclear magnetic resonance signals for the target chemical component selected at the step (a) from the spectral data derived at the step (2c); and (3) determining a best setting of the RF power for which the signal strength of the nuclear magnetic resonance signals for the target chemical component selected at the step (a) is maximum in accordance with the signal strength determined at the step (2d) for each setting of the RF power; (c) applying the RF pulses to the object to be examined placed under the static magnetic field and the gradient magnetic fields; (d) collecting the nuclear magnetic resonance signals from the object to be examined due to the RF pulses applied at the step (c); and (e) deriving at least one of the spectral data and nuclear magnetic resonance spectroscopic images for the target chemical component selected at the step (a) from the nuclear magnetic resonance signals collected at the step (d).

According to another aspect of the present invention there is provided an apparatus for nuclear magnetic resonance spectroscopy, comprising: means for selecting a target chemical component; means for applying an RF pulses to an object to be examined placed under a static magnetic field and a gradient magnetic fields; means for collecting the nuclear magnetic resonance signals from the object to be examined due to the RF pulses applied by the applying means; means for deriving at least one of the spectral data and nuclear magnetic resonance spectroscopic images for the target chemical component selected by the selecting means from the nuclear magnetic resonance signals collected by the collecting means; means for setting an RF power to be supplied to an RF pulse applying means to a level for which a signal strength of nuclear magnetic resonance signals for the target chemical component selected by the selecting means is maximum, by: (1) changing the setting of the RF power sequentially to a plurality of different levels; (2) for each setting of the RF power, (2a) applying RF pulses from the applying means to the object to be examined placed under the static magnetic field and the gradient magnetic fields; (2b) collecting the nuclear magnetic resonance signals from the object to be examined due to the RF pulses applied in (2a) by the collecting means; (2c) deriving spectral data by the deriving means from the nuclear magnetic resonance signals collected in (2b); and (2d) determining a signal strength of the nuclear magnetic resonance signals for the target chemical component selected by the selecting means from the spectral data derived in (2c); and (3) determining a best setting of the RF power for which the signal strength of the nuclear magnetic resonance signals for the target chemical component selected by the selecting means is maximum in accordance with the signal strength determined in (2d) for each setting of the RF power.

According to another aspect of the present invention there is provided an apparatus for nuclear magnetic resonance spectroscopy, comprising: means for selecting a target chemical component; means for applying an RF pulses to an object to be examined placed under a static magnetic field and a gradient magnetic fields; means for collecting the nuclear magnetic resonance signals from the object to be examined due to the RF pulses applied by the applying means; means for deriving at least one of the spectral data and nuclear magnetic resonance spectroscopic images for the target chemical component selected by the selecting means from the nuclear magnetic resonance signals collected by the collecting means; and means for setting an RF power to be supplied to an RF pulse applying means to a level for which a signal strength of nuclear magnetic resonance signals for the target chemical component selected by the selecting means is maximum, including: means for changing the setting of the RF power sequentially to a plurality of different levels; means for determining a signal strength of the nuclear magnetic resonance signals for the target chemical component selected by the selecting means from the spectral data derived from the nuclear magnetic resonance signals due to the RF pulses generated at each setting of the RF power; and means for obtaining a best setting of the RF power for which the signal strength of the nuclear magnetic resonance signals for the target chemical component selected by the selecting means is maximum in accordance with the signal strength determined by the determining means for each setting of the RF power.

Other features and advantages of the present invention will become apparent from the following description taken in conjunction with the accompanying drawings.

## BRIEF DESCRIPTION OF THE DRAWINGS

Fig. 1 is a graph showing a relationship among a flip angle, a pulse interval, and a time constant for a relaxation time of a spin in a conventional apparatus for nuclear magnetic resonance spectroscopy .

Fig. 2 is a schematic block diagram for one embodiment of an apparatus for nuclear magnetic resonance spectroscopy according to the present invention.

Fig. 3 is a flow chart for the operation of the apparatus of Fig. 2.

Figs. 4(A) and (B) are illustrations of spectral data to be utilized in the apparatus of Fig. 2 for explaining the operation of selecting a target chemical component.

Figs. 5(A), (B), (C), (D), and (E) are illustrations of examplery spectral data obtained by the apparatus of Fig. 2 for five different RF power settings.

Fig. 6 is a graph of a signal strength versus RF power for the five spectral data of Figs. 5(A), (B), (C), (D), and (E).

## DETAILED DESCRIPTION OF THE PREFERRED EMBODIMENTS

Referring now to Fig. 2, there is shown one embodiment of an apparatus for nuclear magnetic resonance spectroscopy according to the present invention.

In this embodiment, the apparatus comprises an RF pulse generation unit 2 for applying RF pulses A to an object to be examined 1 placed under a static magnetic field and gradient magnetic fields, including an RF coil 21 and a transmitter circuit 22, a receiver circuit 4 for receiving nuclear magnetic resonance signals B from the object to be examined 1, an RF power modification unit 5 for changing an RF power supplied to the RF pulse generation unit 2, a system controller for controlling operation of the apparatus, a display unit 7 for displaying spectral data obtained from the nuclear magnetic resonance signals B to an operator, and a chemical component selection unit 8 such as a keyboard, mouse, or track ball for allowing the operator to make selection of target chemical component.

The system controller 6 further comprises an RF power memory 61 for memorizing the RF power supplies to the RF pulse generation unit 2, a signal strength detection unit 62 for detecting a signal strength of the nuclear magnetic resonance signals B, a signal strength memory 63 for memorizing the signal strength detected by the signal strength detection unit 62, a comparison unit 64 for comparing magnitudes of two signal strengths, a computation unit 65 for performing computation required in signal processing the nuclear magnetic resonance signal B to obtain the spectral data, and a CPU 6 for controlling other elements of the apparatus.

Referring now to Fig. 3 to Fig. 6, the operation of this apparatus will be described.

First, with respect to the object to be examined 1 placed under a static magnetic field and gradient magnetic fields, the RF pulses A are applied by the RF pulse generation unit 2 with a prescribed initial RF power at the step 100.

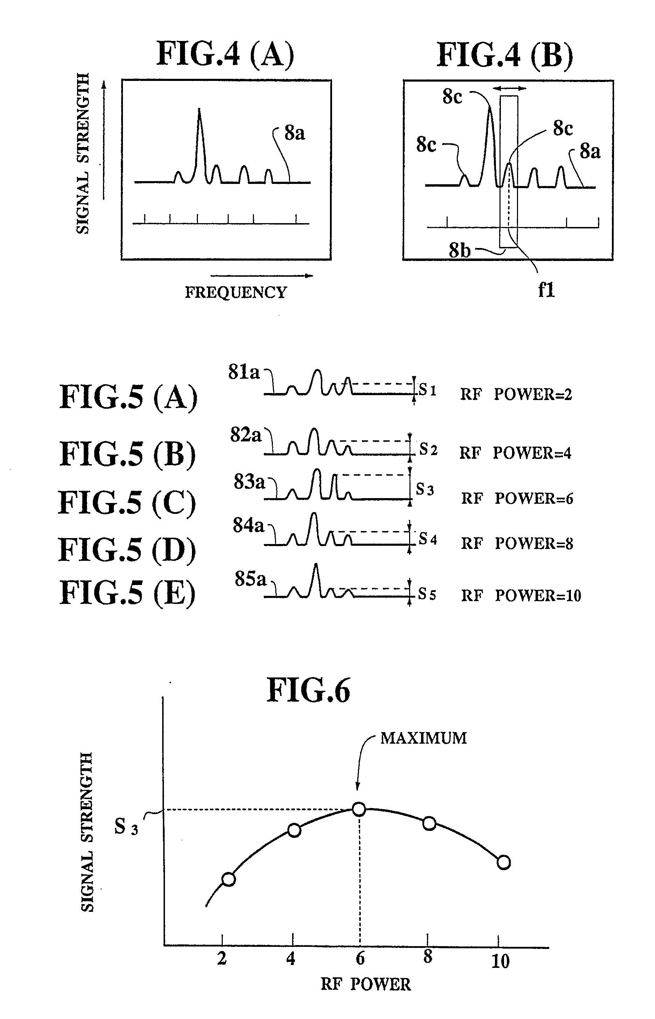

Then, at the step 101, the nuclear magnetic resonance signals B resulting from the application of the RF pulses are collected by the receiver circuit 4, the spectral data are derived from the collected nuclear magnetic resonance signals B at the computation unit 65 under a control of the CPU 66 by Fourier transforming the collected nuclear magnetic resonance signals B, and the derived spectral data are displayed at the display unit 7. Here, the spectral data appear as shown in Fig. 4-(A) in which the spectral data 8a are presented with respect to the vertical and horizontal axes representing the signal strength and the frequency of the collected nuclear magnetic resonance signals B.

Next, at the step 102, the operator at the chemical component selection unit 8 selects the target chemical component, as shown in Fig. 4(B), by specifying one of peaks 8c in the spectral data 8a by means of shifting ROI (region of interest) indication 8b on the display over to the peak to be selected. Here, each one of the peaks 8c corresponds to the nuclear magnetic resonance signals B due to a specific chemical component, so that by specifying one of the peaks 8c, the target chemical component can be specified.

Next, at the step 103, the RF power modification unit 5 is activated so as to set the RF power to be supplied to the RF pulse generation unit 2 at a lowest level. The setting of the RF power is to be modified sequentially in order to search out a best setting, as will be described below.

Next, at the step 104, the current setting of the RF power is memorized at the RF power memory 61 under a control of the CPU 66.

Next, at the step 105, the RF pulses A are applied to the object to be examined 1 by the RF pulse generation unit 2 with the RF power memorized at the step 104, the nuclear magnetic resonance signals B resulting from the application of the RF pulses are collected by the receiver circuit 4, and the spectral data are derived from the collected nuclear magnetic resonance signals B at the computation unit 65 under a control of the CPU 66 by Fourier transforming the collected nuclear magnetic resonance signals B, just as in the steps 100 and 101 above.

Next, at the step 106, a peak value of the peak specified at the step 102 above at the frequency f1 is determined from the spectral data derived at the step 105 by the signal strength detection unit 62.

Then, at the step 107, the peak value determined at the step 106 is compared with the peak value currently memorized in the signal strength memory 63 at the comparison unit 64, and a greater one of the two peak values is memorized in the signal strength memory 63 in correspondence with the current RF power setting memorized in the RF power memory 61. In a case of the lowest RF power setting, the signal strength memory 63 is empty so that the peak value determined at the step 106 enters into the signal strength memory 63.

Next, at the step 108, whether the current RF power setting is equal to a prescribed upper limit for RF power is determined. If so, the process proceeds to the step 110.

If not, the process proceeds to the step 109 in which the RF power setting is raised by a prescribed increment at the RF power modification unit 5 and the process returns to the step 104 described above. In this manner, the setting of the RF power is modified sequentially, and the signal strength of the nuclear magnetic resonance signals B is measured for various RF power settings.

Thus, for instance, the spectral data 81a, 82a, 83a, 84a, and 85a shown in Figs. 5(A), 5(B), 5(C), 5(D), and 5(E), respectively, may be obtained sequentially for the settings of RF power equal to 2, 4, 6, 8, and 10, respectively, from which the peak values S1, S2, S3, S4 and S5, respectively, can be determined for the frequency f1. After all the peak values are measured, what is memorized in the signal strength memory 63 is the maximum peak value among all the peak values measured, which in this example is S3 obtained for the RF power equal to 6 as can be seen from a plot of the signal strengths represented by the various peak values measured versus the RF power settings used shown in Fig. 6.

Now, at the step 110, the RF power setting is set to that memorized in the RF power memory 61 which corresponds to the maximum peak value memorized in the signal strength memory 63 at the RF power modification unit 5, as the best choice for the RF power for which the signal strength of the nuclear magnetic resonance signals B is maximum. In the example mentioned above, the RF power is set to 6 which corresponds to the maximum peak value S3 memorized in the signal strength memory 63.

Then, at the step 111, a scanning for examination is performed to take the nuclear magnetic resonance spectroscopic image or the localized spectrum.

The resulting nuclear magnetic resonance spectroscopic image of the selected chemical component with the best signal/noise ratio can then be displayed at the display unit 7 at the step 112.

This process may be repeated for other selections of chemical component, in order to obtain the nuclear magnetic resonance spectroscopic images with the best signal/noise ratio for the selected chemical components.

Thus, according to this embodiment, it is possible to provide a method and an apparatus for nuclear magnetic resonance spectroscopy capable of obtaining the optimal setting of the RF power for each chemical component of interest, such that the nuclear magnetic resonance spectroscopic images with improved signal/noise ratio become obtainable.

In addition, a plurality of the spectral data are obtained in the process for each RF power setting, so that the plurality of spectral data for the identical flip angle become available since the total magnetic field strength inside the object to be examined is identical for the same RF power setting. Ccmparisons of these plurality of spectral data may be utilized in diagnosis.

It is to be noted that the spectral data may be presented with respect to the vertical and horizontal axes representing the signal strength and the magnetic field strength, instead of the signal strength and the frequency as in the above embodiment.

Also, the maximum signal strength may be determined by utilizing curve fitting calculations such as a least square fitting, instead of selecting from a plurality of choices as in the above embodiment.

Besides these, many modifications and variations of the above embodiments may be made without departing from the novel and advantageous features of the present invention. Accordingly, all such modifications and variations are intended to be included within the scope of the appended claims.

## Claims

1. A method of nuclear magnetic resonance spectroscopy, comprising the steps of:

(a) selecting a target chemical component;

(b) setting an RF power to be supplied to an RF pulse applying means to a level for which a signal strength of nuclear magnetic resonance signals for the target chemical component selected at the step (a) is maximum, by:

(1) changing the setting of the RF power sequentially to a plurality of different levels;

(2) for each setting of the RF power,

(2a) applying RF pulses to an object to be examined placed under a static magnetic field and gradient magnetic fields;

(2b) collecting the nuclear magnetic resonance signals from the object to be examined due to the RF pulses applied at the step (2a);

(2c) deriving spectral data from the nuclear magnetic resonance signals collected at the step (2b); and

(2d) determining a signal strength of the nuclear magnetic resonance signals for the target chemical component selected at the step (a) from the spectral data derived at the step (2c); and

(3) determining a best setting of the RF power for which the signal strength of the nuclear magnetic resonance signals for the target chemical component selected at the step (a) is maximum in accordance with the signal strength determined at the step (2d) for each setting of the RF power;

(c) applying the RF pulses to the object to be examined placed under the static magnetic field and the gradient magnetic fields;

(d) collecting the nuclear magnetic resonance signals from the object to be examined due to the RF pulses applied at the step (c); and

(e) deriving at least one of the spectral data and nuclear magnetic resonance spectroscopic images for the target chemical component selected at the step (a) from the nuclear magnetic resonance signals collected at the step (d).

2. The method of claim 1, wherein at the step (a), the target chemical component is selected by:

(a1) applying RF pulses to the object to be examined placed under the static magnetic field and the gradient magnetic fields;

(a2) collecting nuclear magnetic resonance signals from the object to be examined due to the RF pulses applied at the step (a1);

(a3) deriving spectral data from the nuclear magnetic resonance signals collected at the step (a3); and

(a4) identifying the target chemical component by specifying a peak in the spectral data derived at the step (a3), the peak being representing the nuclear magnetic resonance signals for the target chemical component selected at the step (a).

3. The method of claim 2, wherein the spectral data are given in terms of the signal strength and a frequency of the nuclear magnetic resonance signals, and wherein at the step (a4) of the step (a), the target chemical component is identified by one frequency corresponding to the peak specified.

4. The method of claim 1, wherein at the step (1) of the step (b), the setting of the RF power is changed sequentially by repetition of changing of a previous setting by a prescribed amount, between a lowest level and a highest level.

5. The method of claim 1, wherein at the step (3) of the step (b), the best setting of the RF power is determined by choosing one of the signal strengths determined at the step (2d) with the plurality of different levels of RF power which is greatest.

6. The method of claim 1, wherein at the step (3) of the step (b) the best setting of the RF power is determined by a curve fitting calculation applied to the signal strengths determined at the step (2d) with the plurality of different levels of RF power.

7. An apparatus for nuclear magnetic resonance spectroscopy, comprising:

means for selecting a target chemical component;

means for applying RF pulses to an object to be examined placed under a static magnetic field and gradient magnetic fields;

means for collecting the nuclear magnetic resonance signals from the object to be examined due to the RF pulses applied by the applying means;

means for deriving at least one of the spectral data and nuclear magnetic resonance spectroscopic images for the target chemical component selected by the selecting means from the nuclear magnetic resonance signals collected by the collecting means;

means for setting an RF power to be supplied to an RF pulse applying means to a level for which a signal strength of nuclear magnetic resonance signals for the target chemical component selected by the selecting means is maximum, by:

(1) changing the setting of the RF power sequentially to a plurality of different levels;

(2) for each setting of the RF power,

(2a) applying RF pulses from the applying means to the object to be examined placed under the static magnetic field and the gradient magnetic fields;

(2b) collecting the nuclear magnetic resonance signals from the object to be examined due to the RF pulses applied in (2a) by the collecting means;

(2c) deriving spectral data by the deriving means from the nuclear magnetic resonance signals collected in (2b); and

(2d) determining a signal strength of the nuclear magnetic resonance signals for the target chemical component selected by the selecting means from the spectral data derived in (2c); and

(3) determining a best setting of the RF power for which the signal strength of the nuclear magnetic resonance signals for the target chemical component selected by the selecting means is maximum in accordance with the signal strength determined in (2d) for each setting of the RF power.

8. The apparatus of claim 7, wherein the selecting means selects the target chemical component by:

(a1) applying RF pulses from the applying means to the object to be examined placed under the static magnetic field and the gradient magnetic fields;

(a2) collecting nuclear magnetic resonance signals from the object to be examined due to the RF pulses applied at (a1) by the collecting means;

(a3) deriving spectral data by the deriving means from the nuclear magnetic resonance signals collected in (a3); and

(a4) identifying the target chemical component by specifying a peak in the spectral data derived in (a3), the peak being representing the nuclear magnetic resonance signals for the target chemical component selected by the selecting means.

9. The apparatus of claim 8, wherein the spectral data are given in terms of the signal strength and a frequency of the nuclear magnetic resonance signals, and wherein in (a4), the target chemical component is identified by one frequency corresponding to the peak specified.

10. The apparatus of claim 7, wherein the setting means changes the setting of the RF power in (1) sequentially by repetition of changing of a previous setting by a prescribed amount, between a lowest level and a highest level.

11. The apparatus of claim 7, wherein the setting means determines, in (3), the best setting of the RF power by choosing one of the signal strengths determined in (2d) with the plurality of different levels of RF power which is greatest.

12. The apparatus of claim 11, wherein the setting means includes:
RF power memory means for memorizing each setting of the RF power;
signal strength memory means for memorizing one signal strength in correspondence with the corresponding setting of the RF power in the RF power memory means;
means for comparing each signal strength determined by the determining means with the signal strength memorized in the signal strength memory means at a time of comparison, and storing a greater one of the signal strength in the signal strength memory means, each time the determining means determines the signal strength; and
means for determining the best setting of the RF power by choosing the setting of the RF power memorized in the RF power memory means corresponding to the signal strength memorized in the signal strength memory means after all of the signal strengths for the plurality of different levels of RF power are determined.

13. The apparatus of claim 7, wherein the setting means determines, in (3), the best setting of the RF power by a curve fitting calculation applied to the signal strengths determined in (2d) with the plurality of different levels of RF power.

14. An apparatus for nuclear magnetic resonance spectroscopy, comprising:
means for selecting a target chemical component;
means for applying RF pulses to an object to be examined placed under a static magnetic field and gradient magnetic fields;
means for collecting the nuclear magnetic resonance signals from the object to be examined due to the RF pulses applied by the applying means;
means for deriving at least one of the spectral data and nuclear magnetic resonance spectroscopic images for the target chemical component selected by the selecting means from the nuclear magnetic resonance signals collected by the collecting means; and
means for setting an RF power to be supplied to an RF pulse applying means to a level for which a signal strength of nuclear magnetic resonance signals for the target chemical component selected by the selecting means is maximum, including:
means for changing the setting of the RF power sequentially to a plurality of different levels;
means for determining a signal strength of the nuclear magnetic resonance signals for the target chemical component selected by the selecting means from the spectral data derived from the nuclear magnetic resonance signals due to the RF pulses generated at each setting of the RF power; and
means for obtaining a best setting of the RF power for which the signal strength of the nuclear magnetic resonance signals for the target chemical component selected by the selecting means is maximum in accordance with the signal strength determined by the determining means for each setting of the RF power.

15. The apparatus of claim 14, wherein the selecting means selects the target chemical component by identifying the target chemical component by specifying a peak in the spectral data derived from the nuclear magnetic resonance signals due to the RF pulses, the peak being representing the nuclear magnetic resonance signals for the target chemical component selected by the selecting means.

16. The apparatus of claim 15, wherein the spectral data are given in terms of the signal strength and a frequency of the nuclear magnetic resonance signals, and wherein the selecting means identifies the target chemical component by one frequency corresponding to the peak specified.

17. The apparatus of claim 14, wherein the changing means changes the setting of the RF power sequentially by repetition of changing of a previous setting by a prescribed amount, between a lowest level and a highest level.

18. The apparatus of claim 14, wherein the obtaining means obtains the best setting of the RF power by choosing one of the signal strengths determined by the determining means with the plurality of different levels of RF power which is greatest.

19. The apparatus of claim 18, wherein the setting means includes:
RF power memory means for memorizing each setting of the RF power;
signal strength memory means for memorizing one signal strength in correspondence with the corresponding setting of the RF power in the RF power memory means;
means for comparing each signal strength determined by the determining means with the signal strength memorized in the signal strength memory means at a time of comparison, and storing a greater one of the signal strengths in the signal strength memory means, each time the determining means determines the signal strength; and
means for determining the best setting of the RF power by choosing the setting of the RF power memorized in the RF power memory means corresponding to the signal strength memorized in the signal strength memory means after all of the signal strengths for the plurality of different levels of RF power are determined.

20. The apparatus of claim 14, wherein the obtaining means obtains the best setting of the RF power by a curve fitting calculation applied to the signal strengths determined by the determining means with the plurality of different levels of RF power.

# FIG.1
PRIOR ART

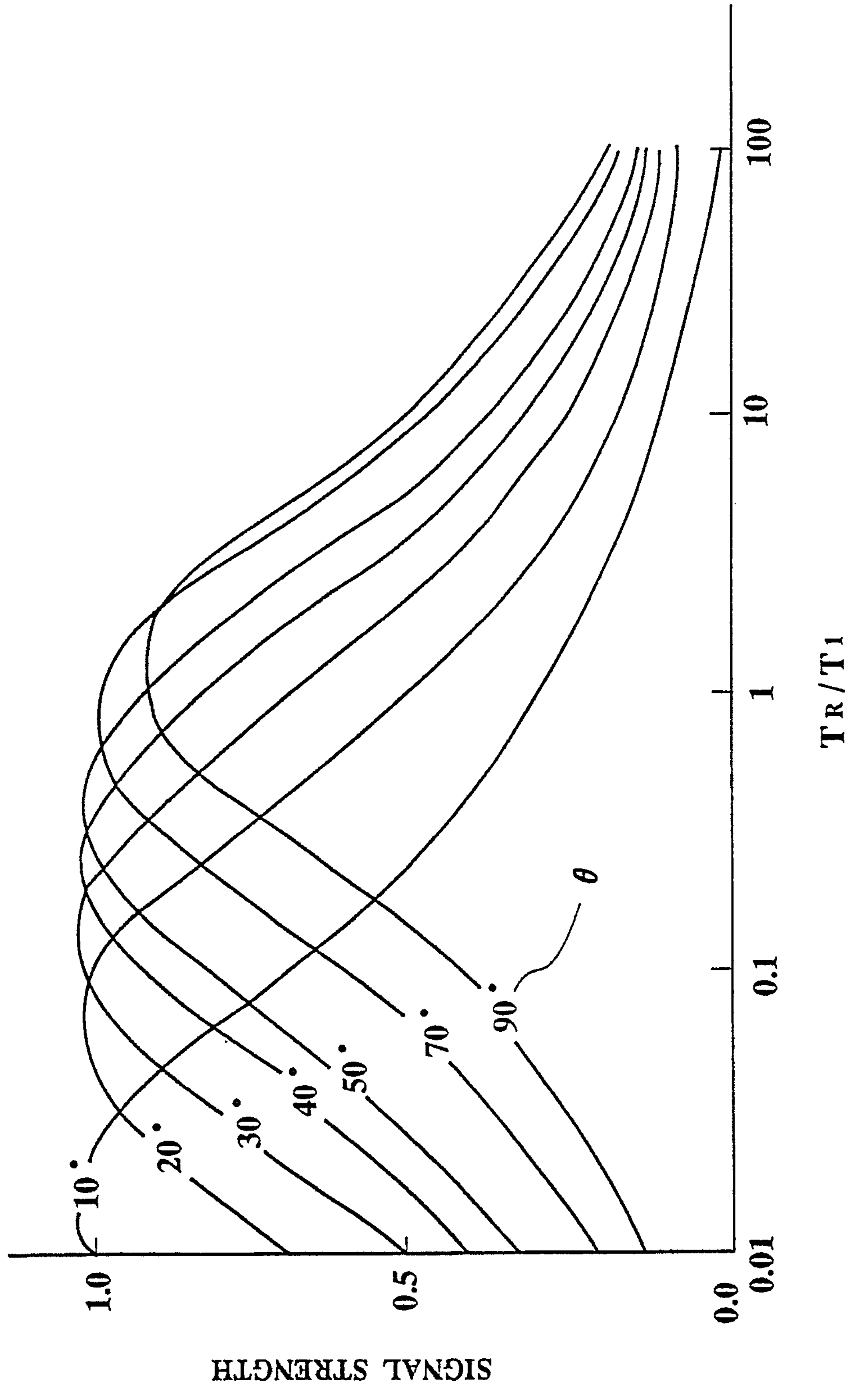

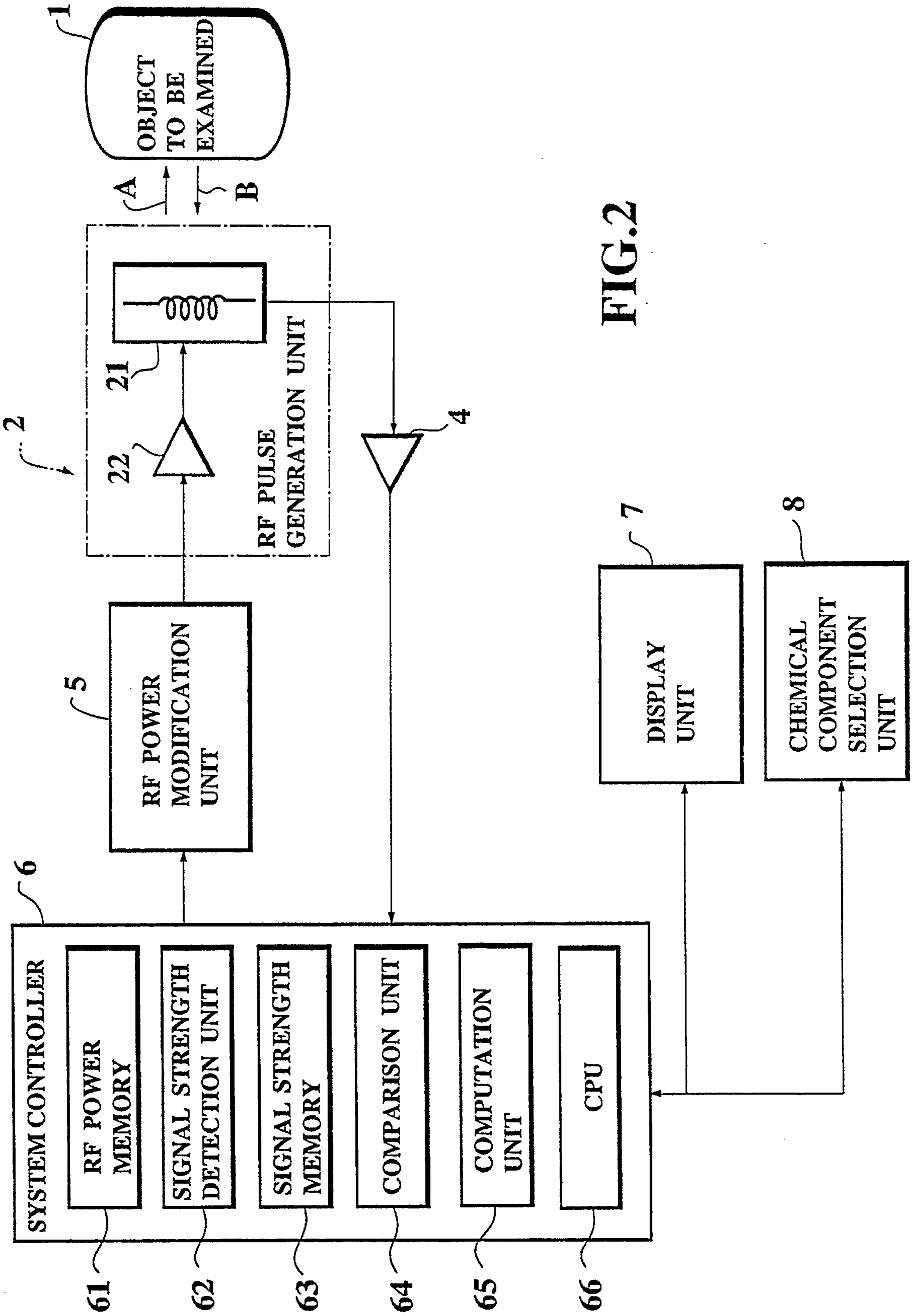
1
OBJECT
TO BE
EXAMINED
A
B
2
21
22
RF PULSE
GENERATION UNIT
4
5
RF POWER
MODIFICATION
UNIT
6
SYSTEM CONTROLLER
RF POWER
MEMORY
SIGNAL STRENGTH
DETECTION UNIT
SIGNAL STRENGTH
MEMORY
COMPARISON UNIT
COMPUTATION
UNIT
CPU
61
62
63
64
65
66
7
DISPLAY
UNIT
8
CHEMICAL
COMPONENT
SELECTION
UNIT

FIG.2

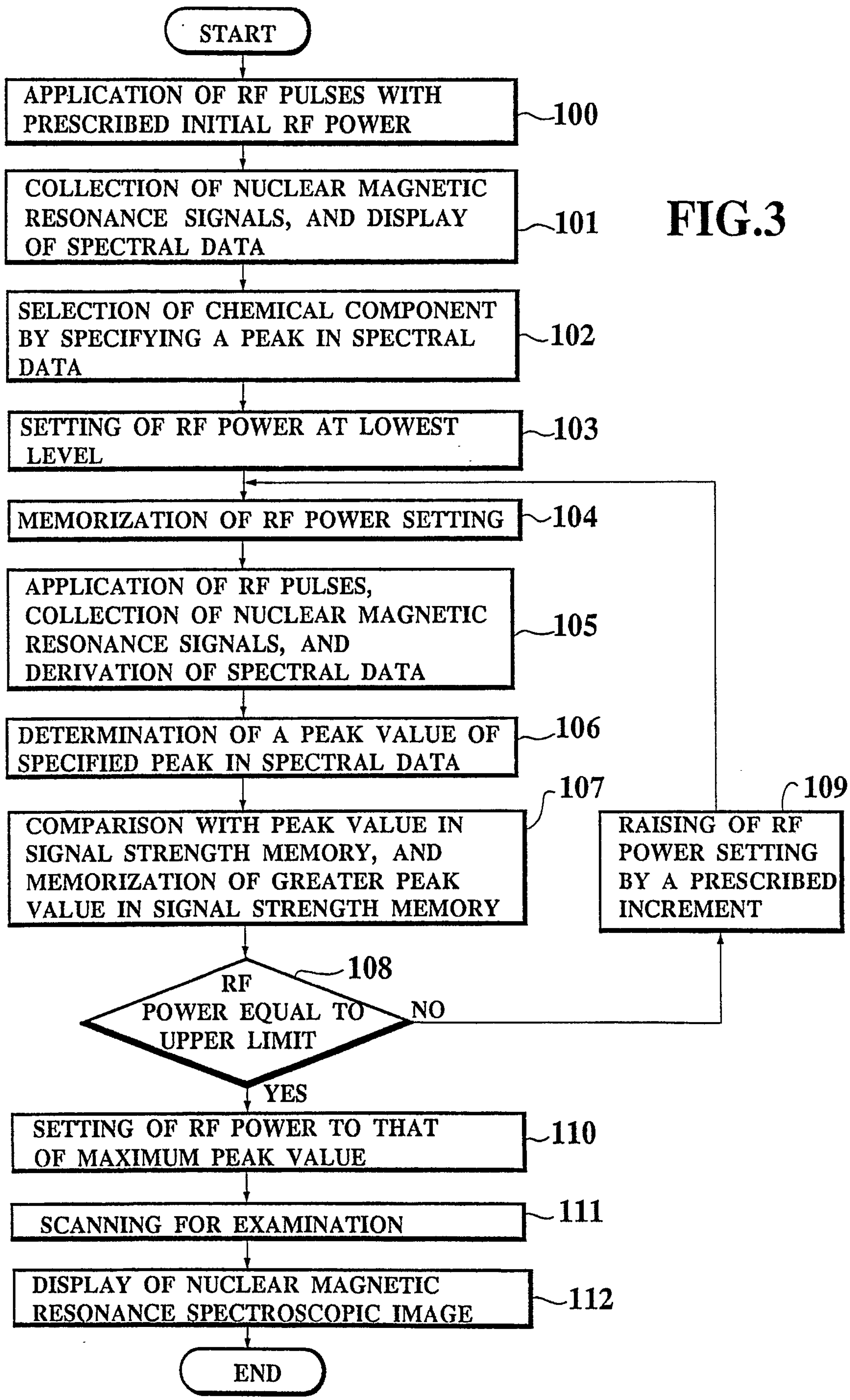
START
APPLICATION OF RF PULSES WITH PRESCRIBED INITIAL RF POWER
100
COLLECTION OF NUCLEAR MAGNETIC RESONANCE SIGNALS, AND DISPLAY OF SPECTRAL DATA
101
SELECTION OF CHEMICAL COMPONENT BY SPECIFYING A PEAK IN SPECTRAL DATA
102
SETTING OF RF POWER AT LOWEST LEVEL
103
MEMORIZATION OF RF POWER SETTING
104
APPLICATION OF RF PULSES, COLLECTION OF NUCLEAR MAGNETIC RESONANCE SIGNALS, AND DERIVATION OF SPECTRAL DATA
105
DETERMINATION OF A PEAK VALUE OF SPECIFIED PEAK IN SPECTRAL DATA
106
COMPARISON WITH PEAK VALUE IN SIGNAL STRENGTH MEMORY, AND MEMORIZATION OF GREATER PEAK VALUE IN SIGNAL STRENGTH MEMORY
107
RAISING OF RF POWER SETTING BY A PRESCRIBED INCREMENT
109
RF POWER EQUAL TO UPPER LIMIT
108
NO
YES
SETTING OF RF POWER TO THAT OF MAXIMUM PEAK VALUE
110
SCANNING FOR EXAMINATION
111
DISPLAY OF NUCLEAR MAGNETIC RESONANCE SPECTROSCOPIC IMAGE
112
END

FIG.3

FIG.4 (A)

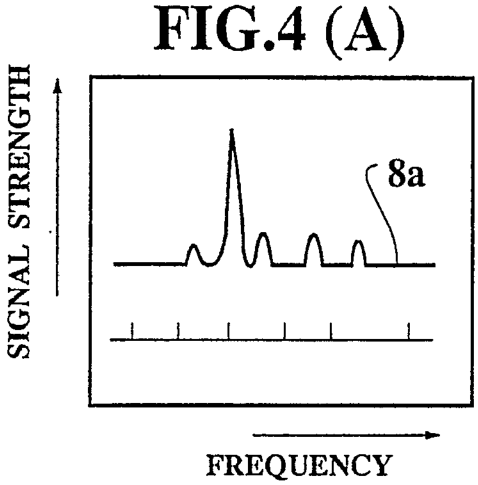


FIG.4 (B)

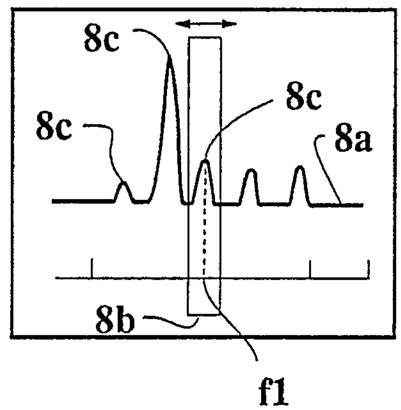


FIG.5 (A)

FIG.5 (B)

FIG.5 (C)

FIG.5 (D)

FIG.5 (E)

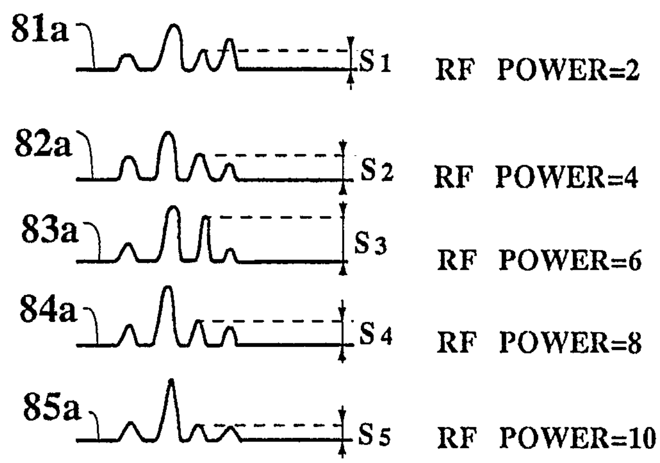


FIG.6